# EUROPEAN PATENT APPLICATION

(11) **EP 1 017 090 A1**
(43) Date of publication of application: **05.07.2000**
(21) Application number: 97940435.7
(22) Date of filing: 19.09.1997
(51) Int. Cl.: H01L 21/304, H01L 21/321, B24B 37/04, B24B 49/00, H01L 21/306

(54) **SEMICONDUCTOR WAFER POLISHING DEVICE**

(30) Priority: 20.09.1996 JP 24972796
(71) Applicant: Speedfam Co., Ltd., Kanagawa 252-1123 (JP)
(72) Inventor: IZUMI, Shigeto, Ayase-shi, Kanagawa 252 (JP); ARAI, Hatsuyuki, Ayase-shi, Kanagawa 252 (JP)
(74) Representative: Lawrence, John Gordon
(86) International application number: JP9703341
(87) International publication number: WO9812739

(57) **Abstract**

A semiconductor wafer polishing apparatus accurately polishes a film formed on the surface of a semiconductor wafer to a predetermined thickness. The semiconductor wafer polishing apparatus (1) for polishing an inter-layer film formed on the surface of the semiconductor wafer by a chemical mechanical polishing process is primarily composed of: a measuring unit (16) for measuring the film thickness of the inter-layer film formed on the semiconductor wafer (3) before and after polishing the semiconductor wafer; and a controller for detecting the polished state of the semiconductor wafer according to the thickness of the inter-layer film measured by the measuring instrument and for comparing the detected polished state with a reference film thickness so as to control the polishing condition of the semiconductor wafer polishing apparatus. With this arrangement, the film thickness of the semiconductor wafer can be detected before and after polishing to enable the polishing condition of the apparatus to be grasped accurately, making it possible to carry out proper polishing according to the grasped polishing condition.

## Description

### TECHNICAL BACKGROUND

The present invention relates to a semiconductor wafer polishing apparatus for polishing an insulating film, which is formed on the surface of a semiconductor wafer, to make it smooth by a chemical mechanical polishing method and, more particularly, to a semiconductor wafer polishing apparatus in which the thickness of an inter-layer on the surface of the semiconductor wafer is measured before and after polishing in the semiconductor wafer polishing apparatus, and the polishing condition is changed as necessary according to the measured film thickness value so as to polish the inter-layer film of the semiconductor wafer to a desired thickness.

### BACKGROUND OF TECHNOLOGY

To fabricate a semiconductor chip, conductive layers, insulating layers, or other layers are laminated in a predetermined pattern in a predetermined order on a semiconductor wafer, then the completed multilayer is cut and divided to chips. Hence, as a pattern layer is stacked on another pattern layer, it develops projections and depressions, and still another pattern layer is stacked on the projections and depressions of the pattern layer thereunder. In this way, the projections and depressions build up as more layers are laminated. Excessively severe projections and depressions on the surface of the topmost layer prevent proper focusing at the time of exposure, and accurate pattern forming cannot be accomplished. As a result, pattern trails, wiring pitches, etc. cannot be reduced, making it impossible to achieve higher integration.

To cope with the problem described above, the inter-layer films of a semiconductor wafer have been polished and smoothed by using a semiconductor wafer polishing apparatus which employs the chemical mechanical polishing process in order to achieve improved focal depth in the lithography of micropatterns, multilayer design of micropatterns, smooth inter-layer insulating films, etc.

To polish the inter-layer films of the semiconductor wafer, however, it is required to adjust and decide the processing condition of the semiconductor wafer polishing apparatus, i.e. diverse factors including the polishing time, the speed of a carrier, polishing pressure, the amount of slurry to be supplied, the rotational speed of a platen, the temperature of the surface of a pad, polishing cloth to be selected, the pressure of a pad conditioner, and backfilling pressure. In addition, the surface of the semiconductor wafer to be polished is pressed against a polishing pad during the polishing process, making it difficult to directly measure the thickness of the remaining film by measuring instruments or the like. For this reason, the polishing amount has conventionally been controlled based on the elapsed polishing time, assuming that the inter-layer film polishing rate stays constant.

Hitherto, to measure the film thickness of a polished semiconductor wafer, the polished semiconductor wafer is washed and dried before it is set on a measuring unit separately installed from the semiconductor wafer polishing apparatus. This has been requiring a few hours to perform the measurement, and there has been another problem in that the obtained measurement data of the film thickness cannot be used as it is for the subsequent polishing mainly because of the changes in the temperature of the polishing cloth in the polishing apparatus.

To be more specific, the measured film thickness of the semiconductor wafer which has been polished by the semiconductor wafer polishing apparatus can be hardly used as the reference value of the current polishing condition because considerable time has already passed since the film thickness of the polished semiconductor wafer was measured, and the operating condition of the semiconductor wafer polishing apparatus is no longer the same.

### DISCLOSURE OF INVENTION

According to the present invention, there is provided a semiconductor wafer polishing apparatus comprising: measuring means for measuring the thickness of an inter-layer film formed on a semiconductor wafer before and after polishing the semiconductor wafer; detecting means for detecting the polished state of the semiconductor wafer according to the thickness of the inter-layer film measured by the measuring means; and controlling means for comparing the polished state detected by the detecting means with a reference film thickness to control the polishing condition of the semiconductor wafer polishing apparatus.

The measuring means is adapted to select a few particular dies among the dies formed on the semiconductor wafer and to select particular places in the pattern of each die so as to measure the film thickness of the particular places. The particular places where the measurement is performed using the measuring means should be a central point and a plurality of points evenly distributed around the central point, e.g. the central point and four points evenly distributed around the central point of the semiconductor wafer. This makes it possible to detect the thickness of the remaining film, the degree of convex or concave configuration, the inclination of the thickness of the remaining film in a particular direction, etc. according to the difference in thickness between the central point and the points around the central point.

A wet measuring means may be used to measure the thickness of the polished semiconductor wafer so as to enable the thickness of the semiconductor wafer immediately after polishing to be measured without the need for subjecting the polished semiconductor wafer to a separately installed cleaning machine and dryer. The polishing process is divided into two steps; the projections and depressions on the surface are smoothed out by first polishing, then the condition for second polishing is presumed from the film thickness obtained by the first polishing. In other words, since the surface of the semiconductor wafer is almost smoothed by the first polishing, the second polishing is carried out at a known polishing speed exhibiting linearity which is decided by a chip pattern; hence, the accurate time required for the second polishing, i.e. the polishing time required for a reference thickness to be reached, can be set.

The semiconductor wafer polishing apparatus will be described in further detail. A plurality of semiconductor wafers to be polished are placed in a container which is set in a predetermined container installing position of the semiconductor wafer polishing apparatus. A moving arm takes out the semiconductor wafers one by one from the container and moves them to the measuring instrument.

The measuring instrument is, for example, a film thickness measuring device making use of reflected light; a beam of light is applied to a predetermined point of the semiconductor wafer to accurately measure the film thickness based on the reflected light, and the obtained value is supplied to a controller. The measuring instrument is equipped with an image processor, moving mechanism, etc. to accurately identify the film thickness measurement points on the semiconductor wafer. The measurement method by the measuring instrument, however, is not limited to the reflection method.

Upon completion of the measurement by the measuring instrument, the semiconductor wafer is removed from the measuring instrument by the moving arm and placed at the mounting position of a turntable which has a position where an unpolished semiconductor wafer is placed and a position where a polished semiconductor wafer is placed and which turns horizontally by any angle with semiconductor wafers mounted thereon. When an unpolished semiconductor wafer is disposed at the mounting position of the turntable, the turntable turns 180 degrees to move the semiconductor wafer to a polishing table. The polishing table is composed primarily of a polishing pad which rotates at a predetermined speed, and an abrasive applying unit; it is equipped, at the top thereof, with a holder which holds a semiconductor wafer and moves up and down, and a carrying mechanism which moves the holder horizontally.

The holder is provided with a suction mechanism based on negative pressure; it lifts a semiconductor wafer by negative pressure when it is moved down onto the semiconductor wafer from the turntable by the carrying mechanism. The lifted semiconductor wafer is moved up and further moved horizontally, then moved down onto the polishing pad of the polishing table by the carrying mechanism. The polishing table applies the polishing abrasive on the surface of the polishing pad and turns to polish the surface of the semiconductor wafer pressed against the polishing pad.

Upon completion of the polishing of the semiconductor wafer, the foregoing procedure is reversed to place the polished semiconductor wafer in a container for holding polished semiconductor wafers. In the middle of the polishing process, the film thickness is measured by the measuring instrument at the same points where the film thickness was measured before polishing, and the measurement result is supplied to the controller.

Then, the controller determines the polished amount of the semiconductor wafer according to the value before polishing and the value after polishing; it also compares the film thickness after polishing with a reference film thickness, and if it finds a difference therebetween, it changes the polishing condition for the subsequent polishing in accordance with the determined polished amount. For instance, the controller changes the polishing condition, namely, it increases or decreases the polishing time or pressing pressure if the average film thickness is different from the reference value. Or if the film thickness is uneven and inclines or if there are projections and depressions between the central point and the points around the central point, then the controller carries out the dressing of the surface of the polishing pad or adjust the pressure of the back surface of the holder to make correction so as to obtain the reference film thickness.

When the semiconductor wafer is subjected further to the second polishing after the first polishing, the controller calculates the time for the second polishing according to the polished amount obtained by the first polishing. During the first polishing, the projections and depressions on the surface of the semiconductor wafer are large, and the polishing speed is high. When the surface becomes smoother as the projections and depressions on the surface are removed, nearly the whole area of the surface come in contact with the polishing pad, and the polishing amount per unit hour becomes a predetermined value, making it easy to guess the polishing amount. Hence, it is possible to calculate the polishing time by taking the polishing amount upon completion of the first polishing as approximately the full surface polishing thereby to determine accurate polishing time. In this case, it is also possible to use two polishing apparatuses to perform the first polishing and the second polishing separately.

Further, the total time required for the polishing can be calculated by adding the time required for the first polishing and the time required for the second polishing obtained above; the determined value is fed back.

### BRIEF DESCRIPTION OF DRAWINGS

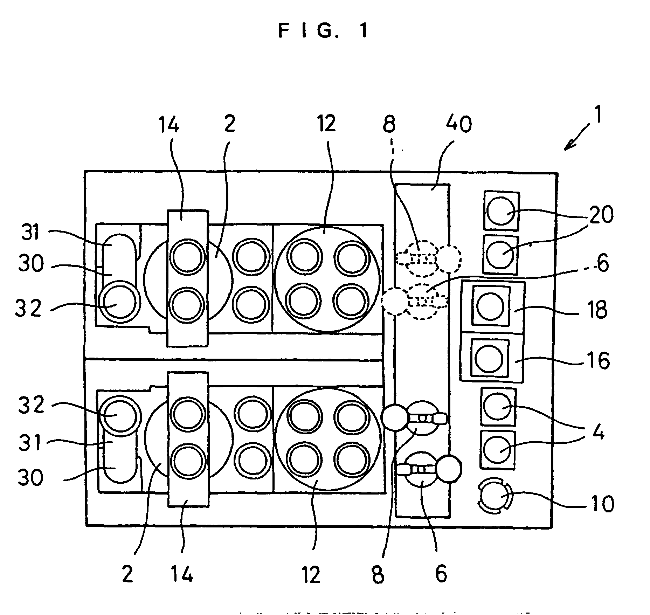

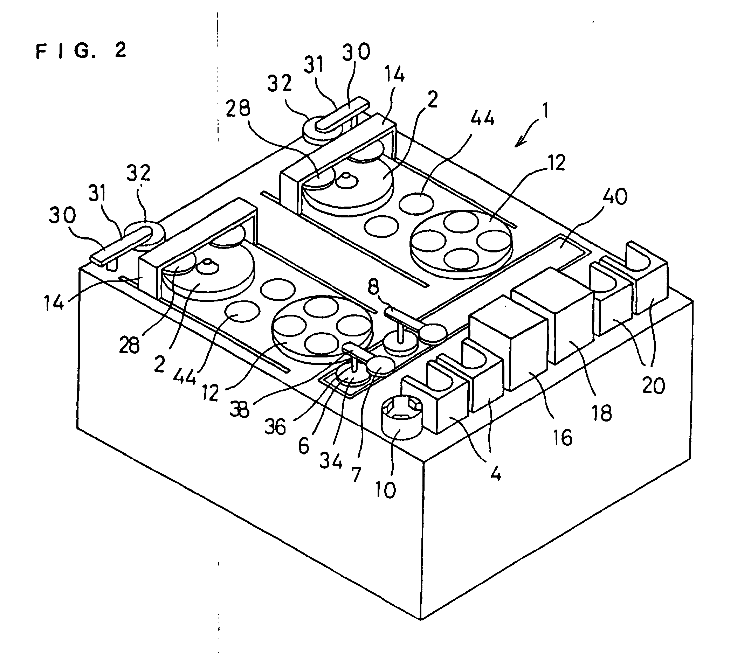

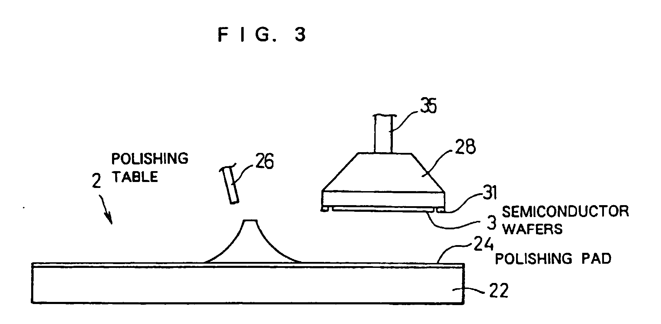

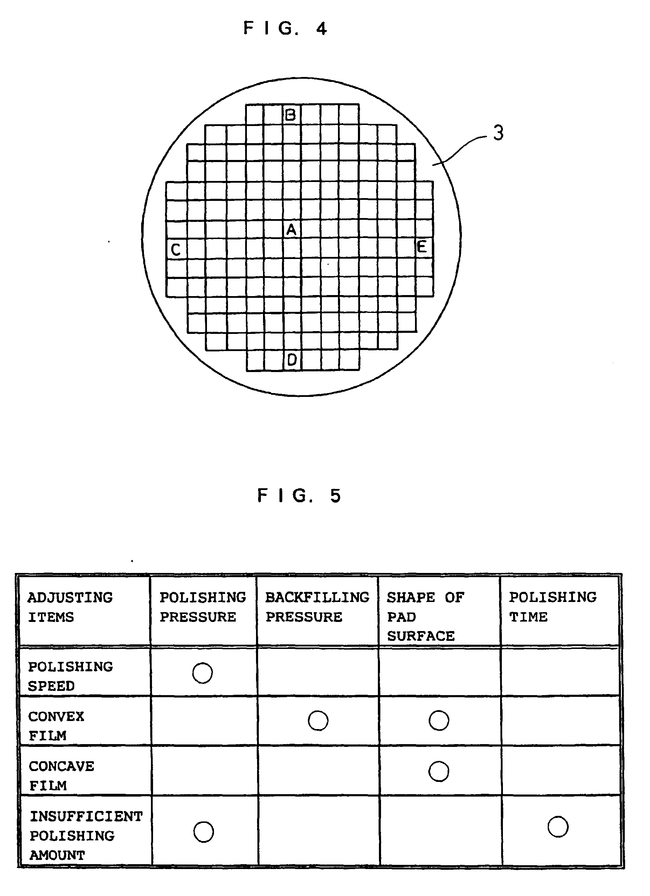

Fig. 1 is a top plan view illustrating an embodiment of a semiconductor wafer polishing apparatus in accordance with the present invention; Fig. 2 is a perspective view illustrating the embodiment of the semiconductor wafer polishing apparatus in accordance with the present invention; Fig. 3 is a partial sectional view illustrating a polishing table; Fig. 4 is a diagram showing a semiconductor wafer; and Fig. 5 is a chart illustrating measurement results in relation to corrective measures.

### BEST MODES FOR PRACTISING INVENTION

An embodiment of the semiconductor wafer polishing apparatus in accordance with the present invention will now be described.

A semiconductor wafer polishing apparatus 1 shown in Fig. 1 and Fig. 2 is constituted primarily by: polishing tables 2 for chemically and mechanically polishing the insulating films of semiconductor wafers 3 shown in Fig. 4; containers 4 for holding the semiconductor wafers 3 before polishing; moving arms 6 for holding and moving the semiconductor wafers 3 before polishing; moving arms 8 for holding and moving the semiconductor wafers 3 after polishing; a center adjuster 10 foe enabling the semiconductor wafers 3 to be held at the centers of the moving arms 6; turntables 12 which turn horizontally with the semiconductor wafers 3 mounted thereon; carriers 14 for carrying the semiconductor wafers 3 from the turntables 12 to the polishing tables 2; a measuring instrument 16 for measuring the thickness of the insulating film of the semiconductor wafer 3 before polishing; a measuring instrument 18 for measuring the thickness of the insulating film of the semiconductor wafer 3 after polishing; and containers 20 for holding the semiconductor wafers 3 after polishing.

The polishing table 2 is composed mainly of a platen 33 which is turned by a rotating mechanism, not shown, a polishing pad 24 pasted to the top surface of the platen 22, and a supplier 26 which supplies an abrasive on the polishing pad 24 as shown in Fig. 3. The carrier 14 which moves longitudinally is installed above the polishing table 2, the carrier 14 being provided with a holder 28. The holder 28 is mounted on the carrier 14 so that it moves up and down; it has a ring 31 around it, and it is connected to a pressure regulator, not shown, to lift and hold the semiconductor wafer 3 by the negative pressure or the like of the pressure regulator. The holder 28 can be rotated about the axis of a shaft 35 by a driving mechanism which is not shown; it is horizontally moved back and forth and also moved up and down by the carrier 14. Hence, the semiconductor wafer 3 held by the holder 28 is pressed against the polishing table 2 while it rotates, and it is further pressed against the polishing table 2 when it moves back and forth.

A dresser 30 for dressing the polishing surface of the polishing table 2 is installed behind the polishing table 2 as shown in Fig. 1. An arm assembly 31 of the dresser 30 circularly moves to dress the polishing surface while turning a dressing blade 32 in a predetermined direction.

The moving arm 6 is composed primarily of a seat 34, a pillar 36 mounted on the seat 34, and an arm 38 rotatably installed on the pillar 36. The seat 34 is able to move along a travel rail 40. The pillar 36 extends and contracts vertically. The arm 38 rotates about the axis thereof and extends and contracts horizontally; it is also able to hold the semiconductor wafer 3 by using suction force produced by negative pressure which is supplied at an end section 7. The moving arm 8 for moving a polished semiconductor wafer has the same composition as the moving arm 6.

The container 4 has multiple shelves to accommodate a plurality of semiconductor wafers 3, and it has a cutout on the front so as to allow the access by the end section 7 of the moving arm 6 which holds the semiconductor wafer 3.

The center adjuster 10 is a position adjuster for matching the center of the semiconductor wafer 3 taken out of the container 4 with the center of the end section 7 of the moving arm 6. The turntable 12 which is rotated by a rotating mechanism, not shown, has four spots formed on the top surface thereof where the semiconductor wafers 3 are rested; two adjacent spots are for the semiconductor wafers 3 before subjected to polishing, and the remaining two adjacent spots are for the semiconductor wafers 3 after subjected to polishing.

Washing sections 44 are installed between the turntables 12 and the polishing tables 2; the washing sections 44 wash the abrasive, etc. off the semiconductor wafers 3 which have been polished by the polishing tables 2 so as to prevent the abrasive from affecting other places.

The measuring instrument 16 measures the thickness of the insulating film formed on the semiconductor wafer 3; it applies a beam of light to the insulating film to measure the thickness of the insulating film by the beam of light reflected by a metal layer or the like. The measuring instrument 16 is equipped with an image processor and a moving mechanism for moving the semiconductor wafer 3, both of which are not shown, so as to measure the thickness of the insulating film at a predetermined point of the semiconductor chip formed on the semiconductor wafer 3.

Fig. 4 shows the examples of the measurement points of the semiconductor wafer 3. The chips located at four points, namely, B, C, D, and E around the center A of the semiconductor wafer 3 are selected, then the same point of each chip is selected to measure the film thickness at the same point of each chip.

The measuring instrument 18 measures the film thickness of the semiconductor wafer 3 which has been polished; it is able to measure the film thickness of the semiconductor wafer 3 which is wet. The measuring instrument 18 is designed so that it is hardly affected by the abrasive remaining on the surface of the semiconductor wafer 3; it basically makes use of the interference by white light to measure the film thickness. As in the case of the measuring instrument 16, the measuring instrument 18 is equipped mainly with an image recognizing device for identifying the same point of a chip formed on the semiconductor wafer, a moving table for moving a thickness sensor and an image sensor, a controller, and a computer for processing data.

The container 20 for holding the semiconductor wafers 3 which have been polished is submerged in a water tank to submerge the semiconductor wafers 3 to prevent it from drying. The moving arm 8 holds the semiconductor wafer 3 which has been polished and moves it from the turntable 12 to the measuring instrument 18, the container 20, etc.

The operation of the semiconductor wafer polishing apparatus 1 will now be described.

First, the semiconductor wafer 3 with various laminated patterns is set in place in the container 4. When the operation of the semiconductor wafer polishing apparatus 1 is started, the moving arm 6 takes out the semiconductor wafer 3 from the topmost shelf of the container 4 and carries it to the measuring instrument 16 to measure the film thickness at the center and at the same point of each of the four chips which are located orthogonally with the center of the semiconductor wafer 3. The measured film thickness values are sent to the controller, and the semiconductor wafer 3 which has been subjected to the measurement of the film thickness is supplied to the center adjuster 10 so as to accurately match the center thereof with the center of the end section 7 of the moving arm 6. After finishing the center adjustment performed by the center adjuster 10, the moving arm 6 sets the semiconductor wafer 3 at the pre-polishing resting location of the turntable 12.

When two semiconductor wafers 3 are placed at the pre-polishing resting locations of the turntable 12, the turntable 12 makes a half turn to feed the semiconductor wafers 3 to the polishing table 2. Then, the holder 28 comes down to lift the semiconductor wafers 3 on the turntable 12 by suction, and the lifted semiconductor wafer 3 are moved by the carrier 14 and put on the platen 22 of the polishing table 2. On the polishing table 2, the platen 22 rotates, the abrasive is supplied from the supplier 26, and the semiconductor wafers 3 are polished by a preset polishing amount. Upon completion of the polishing operation, the carrier 14 carries the holders 28 to the washing sections 44 to remove the abrasive that has adhered to the holders 28 and the semiconductor wafers 3 during the polishing operation. After removing the abrasive, the semiconductor wafers 3 are rested at the post-polishing locations of the turntable 12.

The turntable 12 then makes a half turn to move the semiconductor wafers 3, which have been polished, to the moving arm 8, while at the same time, the semiconductor wafers 3, which have been set at the pre-polishing resting locations of the turntable 12, are moved over to the polishing table 2. The moving arm 8 that handles the semiconductor wafers 3 which have been polished picks up the semiconductor wafers 3 from the turntable 12 and carries them to the measuring instrument 18. The measuring instrument 18 selects the locations which correspond to the locations where the measurement was performed before polishing, measures the film thickness of the semiconductor wafers 3, then sends the measurement results to the controller (not shown).

The controller detects the state of the polished semiconductor wafer 3 according to the values of the film thickness measured before polishing and those after polishing, and compares the film thickness after polishing with the reference value. If the controller determines that the film thickness of the semiconductor wafer 3 exceeds the reference value, then it increases the polishing amount set at the polishing table 2, or if it decides that the polishing amount is too much, then it decreases the polishing amount mainly by shortening the polishing time.

If the controller determines that there are variations in the polishing amount, e.g. if the polishing surface is inclined with respect to the base of the semiconductor wafer 3, or if the polished amount at the central portion is different from that at the area around the central portion, then it changes the pressing pressure of the back surface of the holder 28 or change the condition of the polishing pad 24 by using the dresser 30.

For instance, polished amounts Ra through Re at the points A through E of the semiconductor wafer 3 shown in Fig. 4 are measured, and polished amount Ra at the central portion is compared with a mean value Rh of the polished amounts Rb through Re around the central portion. If the result of the comparison between Ra and Rh indicates that the value of Ra is larger than Rh by a predetermined value or more, meaning that the central portion is thicker, then the controller decides that the central portion is convex; therefore, the controller increases the pressure of the back surface of the holder 28 to increase the pressure applied to the central portion. This increases the pressure applied by the holder to the central portion of the semiconductor wafer 3 to be polished after that, enabling the semiconductor wafer 3 to be provided with uniform film thickness upon completion of polishing.

As an alternative, the controller sends an instruction to the dresser 30 to perform dressing to make the polishing surface of the polishing table 2 convex. This will correct the convex state of the film, so that uniform film thickness is accomplished after polishing, because the polishing process is based on the transfer of the configuration of the surface of the processing pad. At this time, an optimum configuration is created by interlocking the measuring instrument, not shown, for detecting the configuration of the polishing surface, and the dresser 30. On the other hand, if the controller decides that the central portion is thinner and concave, then it sends an instruction to the dresser 30 to make the polishing surface of the polishing table 2 concave by dressing so as to correct the polishing condition thereafter.

Further, the controller determines a mean value Rm of the polished amounts Ra through Re at the respective points A through E in order to determine the uniformity of the polished state from the value obtained by dividing the difference between the maximum value and the minimum value of Ra through Re by Rm; or the controller determines the relationship in magnitude between Rb, Ra, and Rd on the straight line passing through point A in the central portion, and if the magnitude relationship stays constant like, for example, Rb < Ra < Rd, then it decides that there is a slope extending from point D toward point B. These results may be used for feedback. Fig. 5 shows the measurement results in relation to corrective action based on the feedback. As shown in the upper row, if the polishing speed is slow, this can be successfully handled by increasing the polishing pressure. As described above, if the film is convex, the backfilling pressure is increased or the configuration of the pad surface is readjusted to make correction; or if the film is concave, then the configuration of the pad surface is corrected. If the polishing amount is insufficient, the polishing amount is corrected.

The semiconductor wafer 3 which has been subjected to the measurement of the film thickness is moved by the moving arm 8 and placed in the container 20. When the semiconductor wafers 3 which have been polished are placed in the container 20, they are submerged in water to prevent them from drying. When the container is filled up with the semiconductor wafers 3, it is replaced by the container 20 that is empty.

Thus, the semiconductor wafer polishing apparatus 1 in accordance with the present invention measures the film thickness of the semiconductor wafer 3 at the predetermined locations by the measuring instrument 16 before starting polishing the semiconductor wafer 3, measures the film thickness again at the locations corresponding to the locations, where the measurement was performed before polishing, after completion of the polishing operation by the polishing table 2, determines the polishing condition of the polishing apparatus 1 according to the obtained measurement results, and changes the polishing condition as necessary. Hence, a desired polishing condition can be maintained and accurate polishing can be continued without waste.

Another example of the semiconductor wafer polishing apparatus will now be described.

In this example, a film thickness measuring unit, not shown, is installed outside the semiconductor wafer polishing apparatus 1 so that the film thickness of the semiconductor wafer 3 before starting the polishing operation is measured by the film thickness measuring unit installed outside. The measurement result given by this external measuring unit is supplied to the semiconductor wafer polishing apparatus 1; the polished state of the semiconductor wafer 3 on the semiconductor wafer polishing apparatus 1 is determined according to the measurement result supplied before polishing and the measurement result obtained after polishing so as to change the polishing condition as necessary. This also makes it possible to immediately determine the polished state and to achieve proper setting based on the determined polished state, thus enabling accurate, continuous polishing of the semiconductor wafer 3.

In the embodiment and the example described above, the insulating film has been polished, however, the present invention is not limited thereto.

According to the semiconductor wafer polishing apparatus of the present invention, the measuring instruments for measuring the film thickness of a semiconductor wafer before and after polishing are provided, and the polishing conditions and the like are adjusted according to the measurement results given by the measuring instruments. Hence, appropriate polishing condition can be grasped, and the semiconductor wafers can be accurately polished in succession according to the measurement results.

### INDUSTRIAL APPLICABILITY OF INVENTION

The semiconductor wafer polishing apparatus according to the present invention is intended to effect polishing the surface of a semiconductor wafer with difference in level for smoothing. Prior to the polishing, film thickness of the semiconductor wafer is measured and then amount of polishing of the semiconductor wafer is determined on the basis of the measurement result at any time for polishing. Thus it is possible to effect appropriate polishing of the semiconductor wafer by required amount.

## Claims

1. A semiconductor wafer polishing apparatus for polishing an inter-layer film formed on the surface of a semiconductor wafer by a chemical mechanical polishing process, said semiconductor wafer polishing apparatus comprising:
measuring means for measuring the thickness of an inter-layer film formed on said semiconductor wafer before and after polishing said semiconductor wafer;
detecting means for detecting the polished state of said semiconductor wafer according to the thickness of said inter-layer film, measured by said measuring means; and
controlling means for comparing the polished state detected by said detecting means with a reference film thickness of the semiconductor wafer to control the polishing condition of said semiconductor wafer polishing apparatus.

2. A semiconductor wafer polishing apparatus according to Claim 1, wherein said measuring means measures the film thickness at the same locations of a semiconductor chip formed on said semiconductor wafer before and after polishing.

3. A semiconductor wafer polishing apparatus according to Claim 1 or 2, wherein the locations of the measurement by said measuring means include a point in a central area and a plurality of points in areas around the central area which are evenly distributed in the semiconductor wafer.

4. A semiconductor wafer polishing apparatus according to any one of Claims 1 through 3, wherein said measuring means for measuring the film thickness after said semiconductor wafer has been polished is wet type measuring means.

5. A semiconductor wafer polishing apparatus according to any one of Claims 1 through 4, wherein the polishing of said semiconductor wafer is divided into first polishing for nearly smoothing out the projections and depressions on the surface of said semiconductor wafer and second polishing for adjusting the film thickness, the film thickness after said first polishing is measured by said measuring means, and the processing time for said second polishing is determined by using the known polishing amount of said semiconductor wafer, the projections and depressions on the surface of which having been removed.
